# EUROPEAN PATENT APPLICATION

(11) **EP 2 487 686 A2**
(43) Date of publication of application: **15.08.2012**
(21) Application number: 12155091.7
(22) Date of filing: 13.02.2012
(51) Int. Cl.: G11C 7/10

(54) **Semiconductor memory device capable of compression and decompression**

(30) Priority: 14.02.2011 TW 100104692
(71) Applicant: Chang, Sheng-Chuang, Taipei City (TW); Chang, Feng-Chen, Keelung City (TW); Wu, Pao-Tse, Taipei City (TW)
(72) Inventor: Chang, Sheng-Chuang, Taipei City (TW); Chang, Feng-Chen, Keelung City (TW); Wu, Pao-Tse, Taipei City (TW)
(74) Representative: Viering, Jentschura & Partner

(57) **Abstract**

A semiconductor memory device capable of compression and decompression is disclosed. With the semiconductor memory device having a built-in compression function, once external digital data need to be written to the semiconductor memory device, the semiconductor memory device can compress the external digital data and write the compressed external digital data to a semiconductor memory cell array, thereby enhancing data storage capacity. Furthermore, with the semiconductor memory device having a built-in decompression function, once electronic devices need to read data of the semiconductor memory device, the semiconductor memory device can decompress the data and output the decompressed data to the electronic devices.

## Description

### FIELD OF THE INVENTION

The present invention relates to semiconductor memory devices, and more particularly, to a semiconductor memory device capable of compression and decompression and conducive to enhancement of data storage capacity.

### BACKGROUND OF THE INVENTION

A conventional semiconductor memory applicable to solid-state disks (SSD), USB flash drives, memory cards, or electronic devices (such as tablet computers, notebook computers, mobile phones, personal digital assistants, set-top boxes, multimedia players, or game consoles) has limited functions, that is, writing data or reading data. Furthermore, a conventional semiconductor memory has a fixed total memory capacity, and thus the maximum of the total data storage capacity is equal to the total memory capacity.

In view of the aforesaid drawbacks of prior art related to a conventional semiconductor memory, the inventor of the present invention contemplates making inventive improvements in the prior art and thereby puts forth a semiconductor memory device capable of compression and decompression and conducive to enhancement of data storage capacity.

### SUMMARY OF THE INVENTION

It is an objective of the present invention to provide a semiconductor memory device capable of compression and decompression and conducive to enhancement of data storage capacity.

In order to achieve the above and other objectives, the present invention provides a semiconductor memory device capable of compression and decompression. The semiconductor memory device capable of compression and decompression comprises: a semiconductor memory cell array for storing a first compressed data resulting from compression of all data stored in a compression semiconductor memory buffer unit by a compression circuit unit; the compression circuit unit electrically connected to the semiconductor memory cell array, the semiconductor memory buffer unit, and a control circuit unit, and adapted to compress a plurality of data of a specified space; a decompression circuit unit electrically connected to the semiconductor memory cell array, the semiconductor memory buffer unit, and the control circuit unit, and adapted to decompress a second compressed data stored in a specified space of the semiconductor memory cell array and then write the second compressed data thus decompressed to the semiconductor memory buffer unit; the semiconductor memory buffer unit electrically connected to the semiconductor memory cell array, the compression circuit unit, the decompression circuit unit, and the control circuit unit, and adapted to be read and written by the control circuit unit, at least read by the compression circuit unit, and at least written by the decompression circuit unit; the control circuit unit electrically connected to an external address bus, an external data bus, and an external control bus, and adapted to decode signals of the external address bus, instruct the compression circuit unit to compress data denoted with signals of the external data bus according to an address specified by the signal of the external address bus and write the compressed data to a converted corresponding address of the semiconductor memory cell array, and instruct the decompression circuit unit to decompress data at a corresponding address of the semiconductor memory cell array according to an address specified by signals of the external address bus and converted to the corresponding address of the semiconductor memory cell array and then output the decompressed data to the external data bus.

### BRIEF DESCRIPTION OF DRAWINGS

The present invention will become more readily apparent to those ordinarily skilled in the art after reviewing the following detailed description and accompanying drawings, in which:
FIG. 1 is a structural diagram of a semiconductor memory device capable of compression and decompression according to the present invention;
FIG. 2 is a structural diagram of the semiconductor memory device capable of compression and decompression according to FIG. 1 and the preferred embodiment of the present invention;
FIG. 3 is a structural diagram of an address conversion register of the present invention; and
FIG. 4 is a structural diagram of a current address space register of the present invention.

### DETAILED DESCRIPTION OF THE EMBODIMENTS

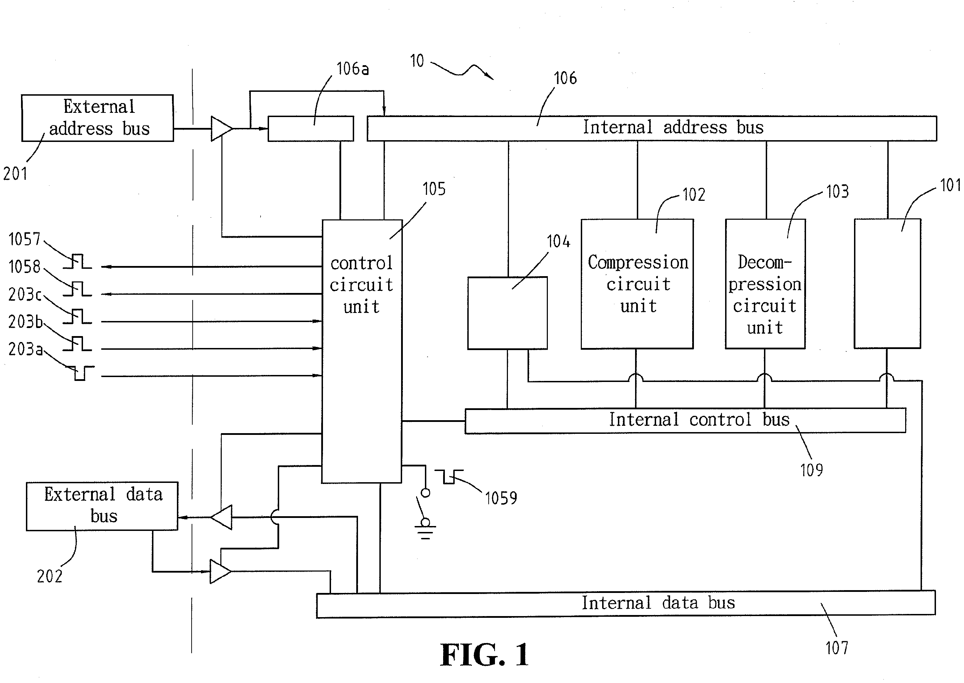

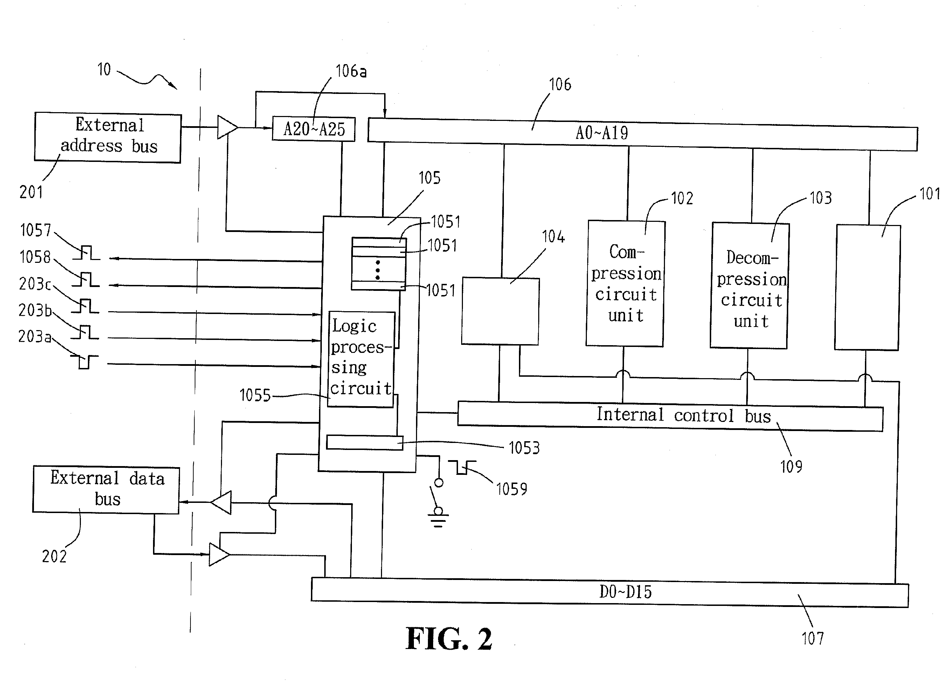

Referring to FIG. 1, 2, 3, and 4, a semiconductor memory device 10 capable of compression and decompression according to the present invention is applicable, for example, to solid-state disks (SSD), USB flash drives, memory cards, or electronic devices (such as tablet computers, notebook computers, mobile phones, personal digital assistants, set-top boxes, multimedia players, or game consoles). With the semiconductor memory device 10 having a built-in compression function, once external digital data need to be written to (or stored in) the semiconductor memory device 10, the semiconductor memory device 10 can compress the external digital data and write the compressed external digital data to a semiconductor memory cell array 101 inside the semiconductor memory device 10; hence, the semiconductor memory device 10 of the present invention is conducive to enhancement of data storage capacity. Furthermore, with the semiconductor memory device 10 having a built-in decompression function, once electronic devices need to read data of the semiconductor memory device 10, the semiconductor memory device 10 can decompress the data and output the decompressed data to the electronic devices.

Electronic devices write data to or read data from the semiconductor memory device 10 of the present invention by means of an address bus, a data bus, and a control bus; hence, the semiconductor memory device 10 of the present invention equals a conventional semiconductor memory in the way of writing data and reading data. Therefore, the semiconductor memory device 10 of the present invention is an alternative to a conventional semiconductor memory.

The semiconductor memory device 10 of the present invention comprises the semiconductor memory cell array 101, a compression circuit unit 102, a decompression circuit unit 103, a semiconductor memory buffer unit 104, and a control circuit unit 105, as described hereunder.

Before describing the functions and structures of the constituent elements of the semiconductor memory device 10 of the present invention, the specification of the present invention hereunder describes how the semiconductor memory device 10 operates in general, such that persons skilled in the art can gain insight into the disclosure and the spirit of the present invention. An external address bus 201 provides a specified address to the control circuit unit 105 for writing data thereto or reading data therefrom. An external read signal 203a and an external write signal 203b are provided to the control circuit unit 105 to instruct the control circuit unit 105 to read data or write data, respectively. When instructed to write data, the control circuit unit 105 receives the data, which are to be written, from an external data bus 202. When instructed to read data, the control circuit unit 105 prepares the data and then outputs the data to the external data bus 202.

Examples given below are illustrative, rather than restrictive, of the present invention. The external address bus 201 has 26 address lines which are defined as address lines A0, A1, ..., A25, and thus the external address bus 201 has a total address space of 64G. The external data bus 202 has 16 data lines which are defined as data lines D0, D1, ..., D15. The semiconductor memory cell array 101 has a total memory capacity of 32G and features a data length of 16 bits. The semiconductor memory buffer unit 104 has a total memory capacity of 1G and features a data length of 16 bits. An internal address bus 106 has 25 address lines. An internal data bus 107 has 16 data lines.

The total address space of the external address bus 201, that is, 64G, is divided according to the total memory capacity of the semiconductor memory buffer unit 104; hence, the total address space of 64G is divided into 64 basic units of address space. In doing so, address lines A0∼A19 serve to point out an address in a basic unit, whereas address lines A20∼A25 serve to specify a specific one of the 64 basic units. Furthermore, the basic unit functions as a unit of the volume of data compressed and decompressed by the compression circuit unit 102 and the decompression circuit unit 103, respectively.

The control circuit unit 105 uses the signals of address lines A20∼A25 of the external address bus 201 and an address conversion data 120 of a current address space register 1053 to judge whether the address space of a basic unit specified by address lines A20∼A25 is located at the semiconductor memory buffer unit 104. If the result of judgment is "true," the control circuit unit 105 will directly access a specified address of the semiconductor memory buffer unit 104 by means of the signals of address lines A0∼A19 of the external address bus 201 and according to the external read signal 203a or the external write signal 203b. If the result of judgment is "false," the control circuit unit 105 will determine whether the address space of a basic unit specified by address lines A20∼A25 is present in the address space of a basic unit corresponding to the semiconductor memory cell array 101, wherein the aforesaid determination is performed by the control circuit unit 105 by making reference to the signals of address lines A20∼A25 of the external address bus 201 and each address conversion data 110 stored in a plurality of address conversion registers 1051.

The control circuit unit 105 obtains the address data of address lines A20∼A25 by means of a high address bus 106a.

Regardless of a result of the aforesaid determination performed by the control circuit unit 105, that is, "present" or "absent," the control circuit unit 105 instructs the compression circuit unit 102 to compress all the existing data in the semiconductor memory buffer unit 104. The compressed data is written back to the original address space of the semiconductor memory cell array 101 according to the address conversion data 120 of the current address space register 1053. Afterward, the address conversion data 110 in a corresponding one of the address conversion registers 1051 is updated; or, alternatively, the compressed data is written to another new address space of the semiconductor memory cell array 101, and then the address conversion data 110 in a corresponding one of the address conversion registers 1051 is updated.

Afterward, if the result of the aforesaid determination performed by the control circuit unit 105 is "present," the control circuit unit 105 will instruct the decompression circuit unit 103 to read and decompress the data of the semiconductor memory cell array 101 of the address space specified by the address conversion data 110 according to the address conversion data 110 of a corresponding one of the address conversion registers 1051 and then write the decompressed data to the semiconductor memory buffer unit 104. Then, the address conversion data 120 in the current address space register 1053 is updated to have the same contents as the address conversion data 110 does. Afterward, the control circuit unit 105 directly accesses the specified address of the semiconductor memory buffer unit 104 by means of the signals of address lines A0∼A19 of the external address bus 201 and according to the external read signal 203a or the external write signal 203b, so as to write the data of the external data bus 202 to the specified address of the semiconductor memory buffer unit 104 or output the data at the specified address of the semiconductor memory buffer unit 104 to the external data bus 202.

If the result of the aforesaid determination performed by the control circuit unit 105 is "absent," the control circuit unit 105 will use address data denoted by address lines A20∼A25 as a new portion of the address conversion data 120 and then write the address conversion data 110 to an unoccupied one of the address conversion registers 1051 or a replaceable one of the address conversion registers 1051. Then, the address conversion data 120 in the current address space register 1053 is updated to have the same contents as the address conversion data 110 does. Afterward, the control circuit unit 105 directly accesses the specified address of the semiconductor memory buffer unit 104 by means of the signals of address lines A0∼A19 of the external address bus 201 and according to the external write signal 203b, so as to write the data of the external data bus 202 to the specified address of the semiconductor memory buffer unit 104. In case of the external read signal 203a, the control circuit unit 105 will output a fault signal 1057, because this data has not yet been present in the semiconductor memory cell array 101.

Once address lines A20∼A25 of the external address bus 201 no longer consecutively point at the corresponding one of the address conversion registers 1051 of the address conversion data 120 created, the control circuit unit 105 will determine that such a situation has happened, and the control circuit unit 105 will search the semiconductor memory cell array 101 for an unoccupied or replaceable block thereof, such that the compressed data resulting from compression of data in the semiconductor memory buffer unit 104 by the compression circuit unit 102 can be written to the block. The control circuit unit 105 will also update the other contents of the address conversion data 110 of the corresponding one of the address conversion registers 1051.

The control circuit unit 105 will output the fault signal 1057, if the control circuit unit 105 fails to find an unoccupied or replaceable one of the address conversion registers 1051 or fails to find an unoccupied or replaceable block.

The functions and structures of the constituent components of the semiconductor memory device 10 of the present invention are described hereunder. The primary purpose of the semiconductor memory cell array 101 is to store the data which originates from the external data bus 202. The data is compressed by the compression circuit unit 102 and then written to a specified address space of the semiconductor memory cell array 101. The semiconductor memory cell array 101 may adopted by one of conventional static random access memories (SRAM), conventional dynamic random access memories (DRAM), or conventional flash memories.

Regarding its primary purposes, the semiconductor memory buffer unit 104 are intended to be accessed (for example, read or written) by the control circuit unit 105, at least read by the compression circuit unit 102, and at least written by the decompression circuit unit 103. The semiconductor memory buffer unit 104 may adopted by one of conventional static random access memories (SRAM), conventional dynamic random access memories (DRAM), or conventional flash memories.

The primary purpose of the compression circuit unit 102 is to receive a command from the control circuit unit 105 for compressing a plurality of data of a specified space, for example, compressing all the data in the semiconductor memory buffer unit 104. Moreover, the compression circuit unit 102 writes the compressed data to a specified address space of the semiconductor memory cell array 101. Furthermore, the compression circuit unit 102 informs a compression processing-related status or data, such as busy decompressing, not busy decompressing, or volume of compressed data to the control circuit unit 105 through an internal control bus 109 and the internal data bus 107. The compression circuit unit 102 may be adopted by a conventional lossless compression technique.

The primary purpose of the decompression circuit unit 103 is to receive a command from the control circuit unit 105 for decompressing a plurality of data of a specified space, for example, decompressing all the data in a specified address space of the semiconductor memory cell array 101. Moreover, the decompression circuit unit 103 writes the decompressed data to the semiconductor memory buffer unit 104. Furthermore, the decompression circuit unit 103 informs a decompression processing-related status or data, such as busy decompressing, not busy decompressing, or having damaged decompression data to the control circuit unit 105 through the internal control bus 109 and the internal data bus 107. The decompression circuit unit 103 may be adopted by a conventional lossless decompression technique as opposed to the aforesaid conventional lossless compression technique.

The control circuit unit 105 comprises the plurality of address conversion registers 1051, the current address space register 1053, and a logic processing circuit 1055, as described hereunder. The primary purpose of the address conversion registers 1051 is to record the address conversion data 110. The quantity of the address conversion registers 1051 is used as a criterion against which the total address space of the external address bus 201, that is, 64G, is divided according to the total memory capacity of the semiconductor memory buffer unit 104; hence, the total address space of 64G is divided into 64 basic units of address space. For example, at least 64 the address conversion registers 1051 are provided.

The address conversion registers 1051 are selectively non-volatile registers.

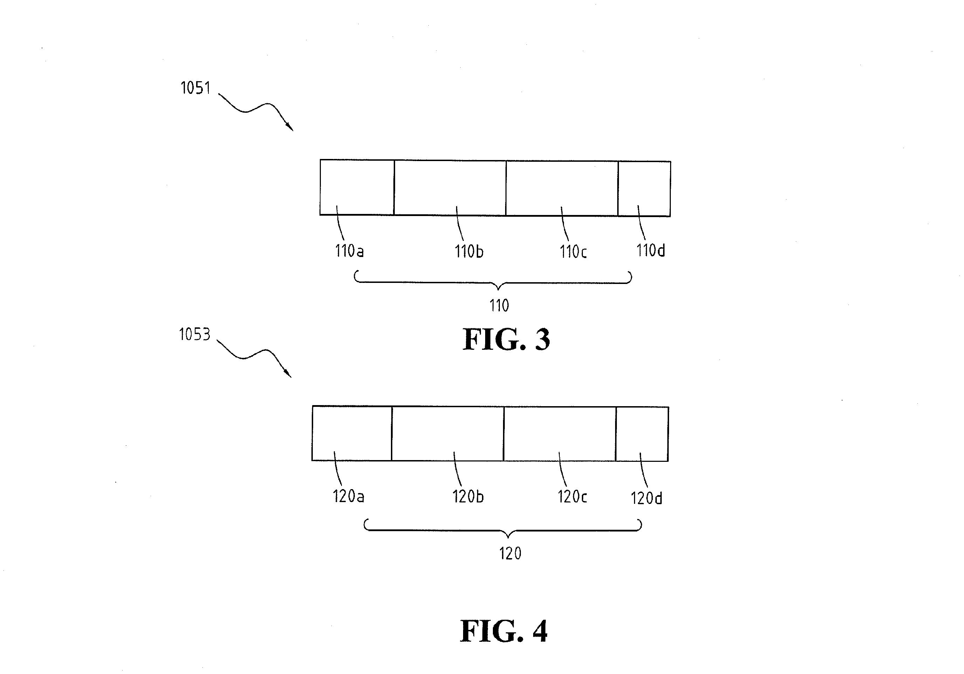

Referring to FIG. 3, the address conversion data 110 at least comprises a basic unit index 110a, a start position index 110b, and an end position index 110c. Referring to the above example, the functions and data structure of the basic unit index 110a, the start position index 110b, and the end position index 110c are described hereunder. The basic unit index 110a points at one of the 64 basic units of the external address bus 201, when the address space of the basic unit pointed out by the basic unit index 110a is associated with the corresponding one of the address conversion registers 1051. For example, the basic unit index 110a has 6 bits for storing the address data of address lines A20∼A25. The start position index 110b and the end position index 110c point at one of the blocks in the semiconductor memory cell array 101, when the block pointed at by the start position index 110b and the end position index 110c corresponds to the associated specified address space of the basic unit. For example, both the start position index 110b and the end position index 110c have 24 bits respectively. The fifth bit through the twenty-fourth bit of the start position index 110b store the address data of address lines A0∼A19. The first bit through the fourth bit of the start position index 110b point out the starting bit of the 16-bit data. Likewise, the fifth bit through the twenty-fourth bit of the end position index 110c store the address data of address lines A0∼A19. The first bit through the fourth bit of the end position index 110c point out the ending bit of the 16-bit data.

Optionally, the address conversion data 110 has a reserved index 110d which has at least one bit for indicating the current status, such as, in operation, not in use, or replaceable, of a corresponding one of the address conversion registers 1051.

Referring to FIG. 4, the current address space register 1053 and the address conversion data 120 have the same structures as the address conversion registers 1051 and the address conversion data 110 do, and the address conversion data 120 at least comprises a basic unit index 120a, a start position index 120b, an end position index 120c, and a reserved index 120d. The functions of the basic unit index 120a, the start position index 120b, and the end position index 120c are the same as those of the basic unit index 110a, the start position index 110b, and the end position index 110c, respectively, and thus are not described hereunder again for the sake of brevity. The reserved index 120d is set aside for future expansion or serves any other purposes.

The logic processing circuit 1055 is electrically connected to the address conversion registers 1051 and the current address space register 1053. The logic processing circuit 1055 can receive a signal from the external address bus 201, a signal from the external data bus 202, and external control signals (such as the external read signal 203a, the external write signal 203b, and an external chip select (CS) signal 203c). The logic processing circuit 1055 functions as the processing core of the control circuit unit 105. The primary purpose of the logic processing circuit 1055 is to perform an operation related to a way of writing data or a way of reading data according to a signal of the external address bus 201, a signal of the external data bus 202, and the external control signals in response to the signal of the external address bus 201, the signal of the external data bus 202, and the external control signals.

The logic processing circuit 1055 of the control circuit unit 105 obtains the address data of address lines A20∼A25 by means of the high address bus 106a.

The semiconductor memory cell array 101, the compression circuit unit 102, the decompression circuit unit 103, the semiconductor memory buffer unit 104, and the logic processing circuit 1055 of the control circuit unit 105 are electrically connected together by the internal address bus 106, the internal data bus 107, and the internal control bus 109. For example, the internal address bus 106 has 25 address lines. For example, the internal data bus 107 has 16 data lines.

If the logic processing circuit 1055 is unable to process a signal of the external buses currently, for example, when the logic processing circuit 1055 is busy, the logic processing circuit 1055 will output a busy signal 1058.

To prevent memory fragmentation of the semiconductor memory cell array 101, the semiconductor memory device 10 of the present invention is designed in a manner as follows: after receiving a memory fragmentation processing signal 1059, the logic processing circuit 1055 moves data stored in the semiconductor memory cell array 101 according to the address conversion data 110 in the address conversion registers 1051 and updates the address conversion data in corresponding ones of the address conversion registers 1051, thereby preventing memory fragmentation.

Assuming a 2:1 ratio of the volume of pre-compression data to be processed by the compression circuit unit 102 to the volume of the resultant compressed data, the semiconductor memory cell array 101 enables a twofold increase in data storage capacity. Referring to the above example, the semiconductor memory device 10 with a data storage capacity of 32G can operate in a way as if it has a total memory capacity of 64G according to the spirit and structure of the present invention.

According to the present invention, the semiconductor memory device 10 capable of compression and decompression can function well with a low-capacity physical semiconductor memory and operate in a way as if it were a high-capacity semiconductor memory. Furthermore, the semiconductor memory device 10 equals a conventional semiconductor memory in an access technique, and thus can substitute for a conventional semiconductor memory in certain aspects of application. The above-mentioned are notable advantages of the present invention in terms of functionality.

The aforesaid description and the accompanying drawings illustrate the preferred embodiment of the present invention, but are not restrictive of the present invention. Hence, any other embodiment similar or identical to the preferred embodiment of the present invention in terms of structure, devices, or features is deemed congruent with the present invention in objectives and should fall within the scope of the claims of the present invention.

## Claims

1. A semiconductor memory device capable of compression and decompression, comprising:
a semiconductor memory cell array for storing a first compressed data resulting from compression of all data stored in a compression semiconductor memory buffer unit by a compression circuit unit;
the compression circuit unit electrically connected to the semiconductor memory cell array, the semiconductor memory buffer unit, and a control circuit unit, and adapted to compress a plurality of data of a specified space;
a decompression circuit unit electrically connected to the semiconductor memory cell array, the semiconductor memory buffer unit, and the control circuit unit, and adapted to decompress a second compressed data stored in a specified space of the semiconductor memory cell array and then write the second compressed data thus decompressed to the semiconductor memory buffer unit;
the semiconductor memory buffer unit electrically connected to the semiconductor memory cell array, the compression circuit unit, the decompression circuit unit, and the control circuit unit, and adapted to be read and written by the control circuit unit, at least read by the compression circuit unit, and at least written by the decompression circuit unit;
the control circuit unit electrically connected to an external address bus, an external data bus, and an external control bus, and adapted to decode signals of the external address bus, instruct the compression circuit unit to compress data denoted with signals of the external data bus according to an address specified by the signals of the external address bus and write the compressed data to a converted corresponding address of the semiconductor memory cell array, and instruct the decompression circuit unit to decompress data at a corresponding address of the semiconductor memory cell array according to an address specified by signals of the external address bus and converted to the corresponding address of the semiconductor memory cell array and then output the decompressed data to the external data bus.

2. The semiconductor memory device capable of compression and decompression of claim 1, wherein the control circuit unit comprises:
a plurality of address conversion registers for storing address conversion data between an address space of the external address bus and an address space of the semiconductor memory cell array;
a current address space register for storing an address conversion data, wherein the address conversion data is corresponding to a portion of an address space of the external address bus, wherein the address space of the external address bus currently corresponds to the semiconductor memory buffer unit; and
a logic processing circuit electrically connected to the address conversion registers and the current address space register, and for determining, according to an address specified by signals of the external address bus, whether the specified address falls within an address space related to an address conversion data in the current address space register, and for determining, according to an address specified by signals of the external address bus, whether the specified address falls within an address space related to an address conversion data in a corresponding one of the address conversion registers, and for converting the specified address into an address of an address space corresponding to the semiconductor memory cell array, instructing the compression circuit unit to compress data denoted with signals of the external data bus according to an address specified by the signals of the external address bus and write the compressed data to a converted corresponding address of the semiconductor memory cell array, and instructing the decompression circuit unit to decompress data at the corresponding address of the semiconductor memory cell array according to an address specified by signals of the external address bus and converted to the corresponding address of the semiconductor memory cell array and then output the decompressed data to the external data bus.

3. The semiconductor memory device capable of compression and decompression of claim 2, wherein the logic processing circuit further determines, according to an address specified by signals of the external address bus, whether the specified address falls within an address space related to an address conversion data in a corresponding one of the address conversion registers, and then create an address conversion data and add the created address conversion data to one of the address conversion registers if a result of the determination is false.

4. The semiconductor memory device capable of compression and decompression of claim 2, wherein the logic processing circuit further determines, according to an address specified by signals of the external address bus, whether the specified address falls within an address space related to an address conversion data in the current address space register, and then instructs, when a result of the determination is false, the compression circuit unit to compress all data in the semiconductor memory buffer unit and then write the compressed data to the corresponding addresses of the semiconductor memory cell array, updates the address conversion data of a corresponding one of the address conversion registers, instructs the decompression circuit unit to decompress at least a data contained within a predetermined address scope of the semiconductor memory cell array corresponding to the specified address and then write the decompressed data to the semiconductor memory buffer unit, and outputs the decompressed data at the specified address to the external data bus.

5. The semiconductor memory device capable of compression and decompression of claim 1, wherein the semiconductor memory cell array is one of static random access memories (SRAM), dynamic random access memories (DRAM), and flash memories, and an address space of the external address bus is larger than a total memory capacity of the semiconductor memory cell array.

6. The semiconductor memory device capable of compression and decompression of claim 1, wherein the semiconductor memory buffer unit is one of static random access memories (SRAM), dynamic random access memories (DRAM), and flash memories, and a total memory capacity of the semiconductor memory buffer unit is less than a total memory capacity of the semiconductor memory cell array.

7. The semiconductor memory device capable of compression and decompression of claim 1, wherein the logic processing circuit is for processing all the data of the semiconductor memory cell array to prevent memory fragmentation.

8. The semiconductor memory device capable of compression and decompression of claim 1, further comprising an internal address bus, an internal data bus, and an internal control bus for connecting the control circuit unit, the semiconductor memory cell array, the compression circuit unit, and the decompression circuit unit.
